(19) **Europäisches Patentamt / European Patent Office / Office européen des brevets**

(11) **EP 4 773 470 A1**

(12) **EUROPEAN PATENT APPLICATION**
published in accordance with Art. 153(4) EPC

(43) Date of publication:
**08.07.2026 Bulletin 2026/28**

(21) Application number: **24859422.8**

(22) Date of filing: **08.08.2024**

(51) International Patent Classification (IPC):
***H02J 50/12*** *(2016.01)*

(52) Cooperative Patent Classification (CPC):
**H02J 50/12**

(86) International application number:
**PCT/JP2024/028581**

(87) International publication number:
**WO 2025/047382 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.08.2023 JP 2023139621**

(71) Applicants:
• **Adtex Inc.**
  **Gunma 370-1201 (JP)**
• **Kake Educational Institution**
  **Okayama-shi, Okayama 700-0005 (JP)**

(72) Inventors:
• **SATO, Hiroo**
  **Takasaki-shi, Gunma 370-1201 (JP)**
• **ISHIDA, Hiroki**
  **Okayama-shi, Okayama 700-0005 (JP)**
• **KOSHINO, Shinji**
  **Takasaki-shi, Gunma 370-1201 (JP)**
• **TAKEDA, Toru**
  **Takasaki-shi, Gunma 370-1201 (JP)**

(74) Representative: **Müller-Boré & Partner**
**Patentanwälte PartG mbB**
**Friedenheimer Brücke 21**
**80639 München (DE)**

(54) **MAGNETIC RESONANCE WIRELESS POWER SUPPLY DEVICE**

(57)    In a magnetic resonance wireless power supply device utilizing PT symmetry and performing contactless power supply by causing magnetic resonance between a power supply coil and a power receiving coil, the magnetic resonance wireless power supply device is provided that can select and fix one of two resonance loops by a method that is not affected by surrounding environment and does not impose the restriction on the design of the power supply coil and the power receiving coil.

A magnetic resonance wireless power supply device utilizing PT symmetry, the magnetic resonance wireless power supply device including a power supply side resonance circuit including a power supply coil and a power receiving side resonance circuit including a power receiving coil. An inverter 3 and a sensor 4 are connected to the power supply side resonance circuit 3. A switch timing, which is the time for turning on or turning off switching elements inside the inverter 3, is determined based on pulses generated by signals after the phase relationship is adjusted by a phase adjustment circuit 30. Thus, one of the two resonance loops is selected and fixed.

Fig. 9

**Description**

TECHNICAL FIELD

The present invention relates to a magnetic resonance wireless power supply device utilizing Parity-Time symmetry (hereinafter referred to as "PT symmetry") for transferring an electric power contactlessly by causing a magnetic resonance between a power supply coil and a power receiving coil.

BACKGROUND OF THE INVENTION

Conventionally, several technologies for the wireless power supply have been known, including an electromagnetic induction system and a magnetic resonance system. Among these, an electromagnetic induction wireless power supply technology is used, for example, for charging mobile phones, where coils are arranged vertically. Namely, based on the same principle as a transformer, the electric power can be transmitted only when the distance (transmission distance) between the power supply coil and the power receiving coil is very close.

However, in the electromagnetic induction wireless power supply technology, the transmission distance is short (e.g., about several millimeters). Thus, a large distance cannot be achieved between the power supply coil and the power receiving coil. In addition, if the positions of the power supply coil and the power receiving coil are misaligned or separated even slightly, neither charging nor power supply is possible (i.e., vulnerable to positional displacement). Therefore, it is difficult to apply to artificial devices installed inside the human body such as an artificial heart or devices with multi-directional rotation or axis misalignment such as a robot arm.

In the magnetic resonance wireless power supply technology, the transmission distance is long (e.g., several centimeters to several meters). The distance between the power supply coil and the power receiving coil can be larger compared to the electromagnetic induction system. Thus, the magnetic resonance wireless power supply technology is at a level close to practical application. However, the electric power cannot be transmitted unless the distance between the power supply coil and the power receiving coil is kept constant and fixed. If the distance becomes closer or farther or if the angles are different, the transmission efficiency decreases and necessary power cannot be transmitted. Thus, the magnetic resonance wireless power supply technology is sensitive. Namely, the magnetic resonance wireless power supply technology is also vulnerable to the positional displacement and difficult to apply to devices (rotating power supply target) with multi-directional rotation or axis misalignment such as a robot arm.

Here, as one wireless power supply method, there is a technology called wireless power supply utilizing the Parity-Time symmetry (hereinafter referred to as "PT symmetry"). The wireless power supply utilizing PT symmetry is a physical system with a non-Hermitian Hamiltonian and is a new concept wireless power supply first published in 2017 (shown in Non-patent Document 1).

When the PT symmetry is preserved, the eigenvalues of the Hamiltonian become real numbers. Thus, although it is a non-Hermitian system, the system energy behaves as if it is conserved. In this case, the energy transferred between the power supply side resonance circuit and power receiving side resonance circuit per unit time becomes independent of the coupling coefficient between the two resonance circuits. As a result, even if the transmission distance changes or the positional displacement occurs in the power supply coil and power receiving coil, the transmission power and the power transmission efficiency are always kept constant as long as the PT symmetry is preserved.

Furthermore, many methods have been proposed for automatically adjusting the frequency of an inverter used as an AC power source for the purpose of suppressing fluctuations in transmission power and power transmission efficiency due to changes in transmission distance (shown in Non-patent Document 2). However, it is impossible to make the transmission power and the power transmission efficiency completely independent of the transmission distance in the above described control methods. This is because all the above described systems are not designed as non-Hermitian physical systems and do not preserve the PT symmetry.

The wireless power supply utilizing the PT symmetry replaces the AC power source in the conventional magnetic resonance wireless power supply technology with an inverter that behaves electrically similar to a negative resistor (i.e., an inverter that behaves as a negative resistance).

This is a known technology as disclosed, for example, in Patent Document 1. To explain in more detail, an inverter that behaves as a negative resistance is an inverter whose switching frequency and voltage amplitude are not fixed in advance, has a circuit configuration where the switching frequency is determined by the apparent resonance frequency of the wireless power supply circuit as seen from the output terminal of the inverter, and is an inverter where the switching frequency follows changes in the apparent resonance frequency of the wireless power supply circuit that may change due to changes in the transmission distance or the positional displacement of coils with fast response speed. Here, the wireless power supply circuit refers to a circuit that includes the power supply side resonance circuit, the power receiving side resonance circuit and all circuits connected thereto. Furthermore, the apparent resonance frequency means the substantial resonance frequency that takes into account the interaction between the power supply side resonance circuit and the power receiving side resonance circuit since they interact with each other.

Furthermore, in the wireless power supply utilizing the PT symmetry, the inverter described above is used by causing self-oscillation. Two modes exist for the oscillation and the PT symmetry can be preserved in either mode. Here, the two modes will be explained in more detail. Fig. 1 is a diagram showing an equivalent circuit of S-P topology, same as Fig. 14 in Patent Document 1.

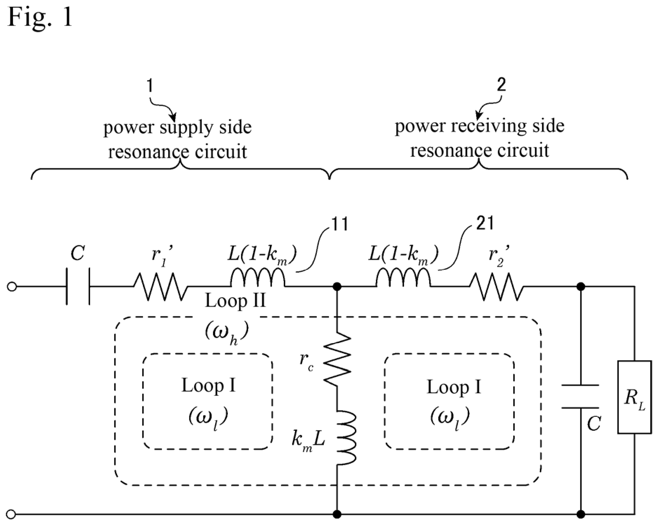

As shown in Fig. 1, a power supply side resonance circuit 1 and a power receiving side resonance circuit 2 of S-P topology can be represented as a coupled resonance circuit coupled via mutual inductance $k_m L$. L in Fig. 1 represents the self-inductance of each of the power supply coil 11 and the power receiving coil 21. $L (1-k_m)$ represents the leakage inductance of each of the power supply coil 11 and the power receiving coil 21. $r_1'$ and $r_2'$ represent the winding resistance of each of the power supply coil 11 and the power receiving coil 21. $r_c$ represents the iron loss equivalent resistance. C represents the capacitance of the capacitor. In the circuit shown in Fig. 1, two resonance loops ("Loop I resonance loop" and "Loop II resonance loop") are formed so that a resonance current flowing through the coupled resonance circuit can circulate. Furthermore, regarding the frequency, the resonance frequency of Loop I is $\omega_l$ and the resonance frequency of Loop II is $w_h$.

However, as shown in the experimental results shown in Non-patent Document 1, the two oscillation modes (resonance loops) may switch unintentionally and spontaneously during operation. When the switching of the oscillation modes (resonance loops) occurs, the operation becomes unstable and the power transmission itself becomes difficult. Thus, a method to reliably select one of the oscillation modes (resonance loops) is necessary.

Therefore, as one method to solve the above described problem, Patent Document 1 proposes a method of selecting one of the resonance loops by adjusting the magnitude of Q values (selectivity) of the two resonance loops through coil design in the magnetic resonance wireless power supply device utilizing the PT symmetry and transmits the electric power contactlessly by causing magnetic resonance between the power supply coil and the power receiving coil.

PRIOR ART DOCUMENTS

Patent documents

Patent Document 1: Japanese Patent Application Publication No. 2022-121324

Non-patent documents

Non-patent Document 1: Sid Assawaworrarit, Xiaofang Yu & Shanhui Fan, "Robust wireless power transfer using a nonlinear parity-time-symmetric circuit", Nature, 15 JUNE 2017, volume 546, p.387-390
Non-patent Document 2: A.P.Sample, D.T.Meyer & J.R.Smith, "Analysis, experimental results, and range adaptation of magnetically coupled resonators for wireless power transfer", IEEE Trans. Ind. Electron., 2011, vol.58, no.2, pp.544-554
Non-patent Document 3: J. Zhou, B. Zhang, W. Xiao, D. Qiu, and Y. Chen, "Nonlinear parity-time-symmetric model for constant efficiency wireless power transfer: application to a drone-in-flight wireless charging platform", IEEE Trans. Ind. Electron., Aug. 2019, vol.66, no.5, pp.4097-4107
Non-patent Document 4: H. Ishida, T. Kyoden, and H. Furukawa, "Application of parity-time symmetry to low-frequency wireless power transfer system", IEEJ J. Ind. Appl., 2022, vol.11, no.1, pp.59-68

SUMMARY OF THE INVENTION

Problem to be Solved by the Invention

However, in the magnetic resonance wireless power supply devices shown in Patent Document 1 and the like, a method of selecting one of the resonance loops by adjusting the magnitude of Q values (selectivity) of the two resonance loops through coil design is adopted. Thus, there is an application-related problem in which the design of the power supply coil and the power receiving coil is restricted and the shape and the size of the coils cannot be freely determined.

The present invention is made to solve the above described problems, and aims to provide a magnetic resonance wireless power supply device utilizing PT symmetry and performing contactless power supply by causing magnetic resonance between the power supply coil and the power receiving coil, capable of selecting and fixing one of the two resonance loops by a method that is not affected by surrounding environment and does not impose the restriction on the design of the power supply coil and the power receiving coil.

Means for Solving the Problem

In order to solve the above described problems, the present invention is a magnetic resonance wireless power supply device utilizing Parity-Time symmetry, the magnetic resonance wireless power supply device including: a power supply side resonance circuit including a power supply coil; and a power receiving side resonance circuit including a power receiving coil, wherein an electric power is transferred contactlessly by causing a magnetic resonance between the power supply coil and the power receiving coil, when the power supply side resonance circuit and the power receiving side resonance circuit are regarded as a coupled resonance circuit coupled to each other via mutual inductance, two resonance loops of "Loop I resonance loop" and "Loop II resonance loop" are formed so that a resonance current flowing through the coupled resonance circuit can circulate, an inverter and a sensor that detects a current or a magnetic field of the power supply coil are connected to the power supply side resonance circuit, and the inverter includes a phase adjustment circuit capable of adjusting a phase relationship between an AC voltage applied to the power supply side resonance circuit and an AC current flowing through the power supply coil using a current phase of the current of the power supply coil and detected by the sensor or a magnetic field phase of the magnetic field of the power supply coil and detected by the sensor as a reference, and a switch timing, which is a time for turning on or turning off a switching element inside the inverter, is determined based on a pulse generated by a signal after the phase relationship is adjusted by the phase adjustment circuit so that one of the two resonance loops is selected and fixed.

Effect of the Invention

According to the present invention, in the magnetic resonance wireless power supply device utilizing the PT symmetry and performing the contactless power supply by causing the magnetic resonance between the power supply coil and the power receiving coil, the phase adjustment circuit is provided for adjusting the phase relationship between the AC voltage applied to the power supply side resonance circuit and the AC current flowing through the power supply coil. Thus, it is possible to select and fix one of the two resonance loops by a method that is not affected by surrounding environment and does not impose the restriction on the design of the power supply coil and the power receiving coil.

BRIEF DESCRIPTION OF DRAWINGS

Fig. 1 is a drawing showing an equivalent circuit of S-P topology.
Figs. 2A and 2B are conceptual drawings showing two representative circuit configurations of a magnetic resonance wireless power supply utilizing PT symmetry.
Fig. 3 is a graph of numerical calculation results showing a typical example of the relationship between a magnetic coupling coefficient $k_m$ and a transmission distance d between two coils (power supply coil and power receiving coil).
Fig. 4 is a graph showing the relationship between a resonance frequency $\omega_h$ of Loop II and a resonance frequency $\omega_l$ of Loop I and a transmission distance d between two coils (power supply coil and power receiving coil).
Fig. 5 is a circuit diagram when Class D inverter is connected to the power supply side resonance circuit as an inverter used for the wireless power supply utilizing the PT symmetry.
Fig. 6 is a schematic diagram showing the phase relationship of each waveform in the power supply side resonance circuit shown in Fig. 5.
Figs. 7A to 7C are experimental results showing the phase relationship between an AC current $i_1$ and an input voltage $v_1$.
Fig. 8 is a circuit diagram showing an equivalent circuit of the wireless power supply connected to the inverter.
Fig. 9 is a circuit diagram showing an example of an inverter with a phase adjustment circuit and a power supply side resonance circuit in the embodiment 1 of the present invention.
Fig. 10 is a schematic diagram showing voltage waveforms of each part of the phase adjustment circuit (pre-amplifier 36 and phase lag circuit 35) shown in Fig. 9.
Fig. 11 is a circuit diagram showing an example of an inverter with a time delay circuit and a power supply side resonance circuit in the embodiment 1 of the present invention.
Fig. 12 is a circuit diagram showing an example of an inverter with an all-pass filter and a power supply side resonance circuit in the embodiment 1 of the present invention.
Fig. 13 is a circuit diagram showing an example of an inverter with a PLL (phase-locked loop) and a supply side resonance circuit in the embodiment 1 of the present invention.
Fig. 14 is a block diagram showing an example of specific internal functions of the PLL (phase-locked loop) in the embodiment 1 of the present invention.
Fig. 15 is a circuit diagram showing an example of an inverter with an all-pass filter and a PLL (phase-locked loop) and a power supply side resonance circuit in the embodiment 1 of the present invention.

Fig. 16 is a graph showing measured waveforms of the AC current $i_1$ and the input voltage $v_1$ when the input voltage $v_1$ is adjusted to have a leading phase with respect to the AC current $i_1$ in an actual device in the embodiment 1 of the present invention.

Fig. 17 is a graph showing results of measuring changes in the resonance frequency when the distance between the power supply coil 11 provided in the power supply side resonance circuit 1 and the power receiving coil 21 provided in the power receiving side resonance circuit 2 (i.e., the transmission distance d between the two coils) is varied in the phase relationship in Fig. 16.

Fig. 18 is a graph showing results of measuring the transmission power when the transmission distance d between the two coils is varied.

MODES FOR CARRYING OUT THE INVENTION

The present invention relates to a magnetic resonance wireless power supply device utilizing Parity-Time symmetry (hereinafter referred to as "PT symmetry") for transmitting an electric power contactlessly by causing magnetic resonance between a power supply coil and a power receiving coil.

The embodiments of the present invention will be described in detail below with reference to the drawings.

Embodiment 1

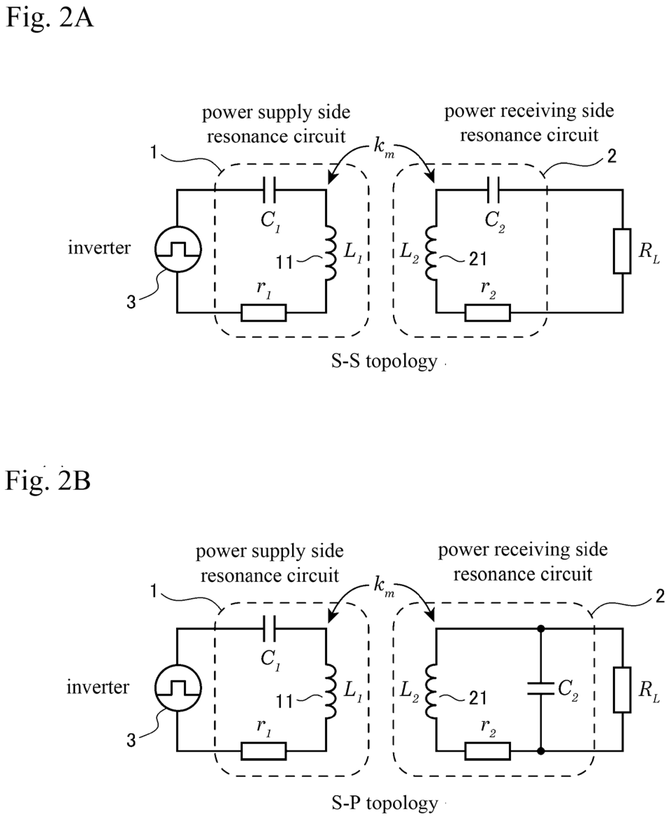

Figs. 2A and 2B are conceptual drawings showing two representative circuit configurations of a magnetic resonance wireless power supply utilizing PT symmetry. In both circuit examples shown in Figs 2A and 2B, the power supply side resonance circuit 1 is connected to an inverter 3 as an AC power source. On the other hand, a load of the load resistance $R_L$ is connected to the power receiving side resonance circuit 2. In the above described circuits, $L_1$ represents the self-inductance of the power supply coil 11, $C_1$ represents the capacitance of the power supply side capacitor, $L_2$ represents the self-inductance of the power receiving coil 21, and $C_2$ represents the capacitance of the power receiving side capacitor. Furthermore, $r_1$ and $r_2$ represent the resistance components included in the power supply side resonance circuit 1 and the power receiving side resonance circuit 2 respectively.

The circuit example shown in Fig. 2A is called S-S topology because the coil and the capacitor of the power supply side resonance circuit 1 are connected in series, and the coil and the capacitor of the power receiving side resonance circuit 2 are also connected in series. The circuit example shown in Fig. 2B is called S-P topology because the coil and capacitor of the power supply side resonance circuit 1 are connected in series, and the coil and the capacitor of the power receiving side resonance circuit 2 are connected in parallel. The example of the wireless power supply that preserves the PT symmetry in S-S topology is disclosed in Non-patent Document 3. The example of the wireless power supply that preserves the PT symmetry in S-P topology is disclosed in Non-patent Document 4.

Here, although the explanation is repeated, the explanation will be made using the equivalent circuit of S-P topology shown in Fig. 1 as an example. The power supply side resonance circuit 1 and the power receiving side resonance circuit 2 of S-P topology can be represented as a coupled resonance circuit coupled by mutual inductance $k_mL$. Furthermore, L in Fig. 1 represents the self-inductance of each of the power supply coil 11 and the power receiving coil 21. L $(1- k_m)$ represents the leakage inductance of each of the power supply coil 11 and the power receiving coil 21. Furthermore, $r_1'$ and $r_2'$ represent the winding resistance of each of the power supply coil 11 and the power receiving coil 21. $r_c$ represents the iron loss equivalent resistance. C represents the capacitance of the capacitor. In the circuit shown in Fig. 1, two resonance loops ("Loop I resonance loop" and "Loop II resonance loop") are formed so that the resonance current flowing in the coupled resonance circuit can circulate. Furthermore, regarding the frequency, the resonance frequency of Loop I is $w_l$, and the resonance frequency of Loop II is $\omega_h$.

Furthermore, in the wireless power supply device utilizing the PT symmetry in the embodiment 1 of the present invention, as described above, the inverter is used by causing self-oscillation, two modes exist for oscillation, and the PT symmetry can be preserved in either mode, same as the conventional systems. Needless to say, as shown in Fig. 1 and Figs. 2A and 2B, the power supply side resonance circuit 1 includes the power supply coil 11 and the power receiving side resonance circuit 2 includes the power receiving coil 21.

In both topologies shown in Figs. 2A and 2B, the wireless power supply circuit seen from the output terminal of the inverter 3 forms a coupled resonance circuit, and two resonance loops exist. However, the exact mathematical formulas for the two resonance loops cannot be derived from the circuit diagrams shown in Figs. 2A and 2B. This can be rigorously obtained from coupled mode theory, and the derivation process is shown in Non-Patent Document 4 (as shown by one of the applicants of the present application in Non-patent Document 4). Here, detailed explanation and derivation process are omitted and only the results are shown in the following equations (1) and (2).

[Equation 1]

$$\omega_h = \omega_0 + \sqrt{(k^2 - (\Gamma_{20} + \Gamma_L)^2)} \quad \text{--- (1)}$$

[Equation 2]

$$\omega_l = \omega_0 - \sqrt{(k^2 - (\Gamma_{20} + \Gamma_L)^2)} \quad \text{--- (2)}$$

Namely, a resonance loop with the resonance frequency $\omega_h$ shown in Equation (1) and a resonance loop with the resonance frequency $\omega_l$ shown in Equation (2) are formed. The two resonance loops have the relationship $\omega_h > \omega_l$. $\omega_0$ is the natural angular resonance frequency when the power supply side resonance circuit and the power receiving side resonance circuit are far apart and completely uncoupled, and can be expressed by Equation (3). Note that $\Gamma_{20}$ and $\Gamma_L$ in Equations (1) and (2) are both parameters (CMT parameters) in coupled mode theory. While these are explained in detail in Patent Document 1 (as shown by one of the applicants of the present application in Patent Document 1 and Non-patent Document 4), since they have little relevance to the explanation of the present invention and the explanation of their definitions would be lengthy, detailed explanation is omitted here.

[Equation 3]

$$\omega_0 = 1/\sqrt{(L_1 C_1)} = 1/\sqrt{(L_2 C_2)} \quad \text{--- (3)}$$

Furthermore, k is a parameter called coupling rate, which relates to the number of times the energy is exchanged per unit time between the power supply side resonance circuit and the power receiving side resonance circuit. Furthermore, the coupling rate k can be expressed using the magnetic coupling coefficient $k_m$ between the power supply coil and the power receiving coil as shown in Equation (4).

[Equation 4]

$$k = (\omega_0 k_m)/2 \quad \text{--- (4)}$$

Here, for example, when Equations (1) and (2) are applied to the case of S-P topology in Fig. 2B, they can be expressed as the following Equations (5) and (6).

[Equation 5]

$$\omega_h = 1/\sqrt{(L_2 C_2)} + \sqrt{((\omega_0 k_m/2)^2 - (r_2/(2L_2) + 1/(2C_2 R_L))^2)} \quad \text{--- (5)}$$

[Equation 6]

$$\omega_l = 1/\sqrt{(L_2 C_2)} - \sqrt{((\omega_0 k_m/2)^2 - (r_2/(2L_2) + 1/(2C_2 R_L))^2)} \quad \text{--- (6)}$$

Note that the above described Equations (5) and (6) can also be approximately expressed as Equations (7) and (8). In Patent Document 1, the approximate equations (7) and (8) are used for explanation.

[Equation 7]

$$\omega_h = 1/\sqrt{(L_2 C_2 (1 - k_m))} \quad \text{--- (7)}$$

[Equation 8]

$$\omega_l = 1/\sqrt{(L_2 C_2 (1 + k_m))} \quad \text{--- (8)}$$

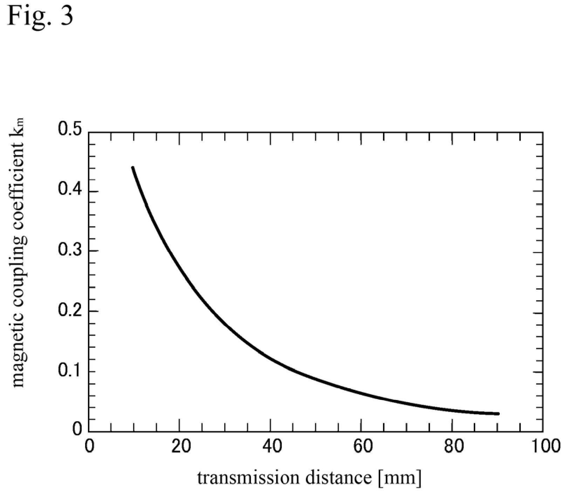

It can be seen from Equations (5) and (6) that the resonance frequency $\omega_h$ of Loop II and the resonance frequency $\omega_l$ of Loop I are functions only of the magnetic coupling coefficient $k_m$. For complex coil shapes, it is difficult to formulate the relationship between the magnetic coupling coefficient $k_m$ and the distance d (transmission distance) between the power supply coil and the power receiving coil. It is generally obtained by numerical calculation using computers. However, the relationship where the magnetic coupling coefficient $k_m$ is inversely proportional to the transmission distance d between coils is universal. Fig. 3 is a graph of numerical calculation results showing a typical example of the relationship between the magnetic coupling coefficient $k_m$ and the transmission distance d between two coils (power supply coil and power receiving coil).

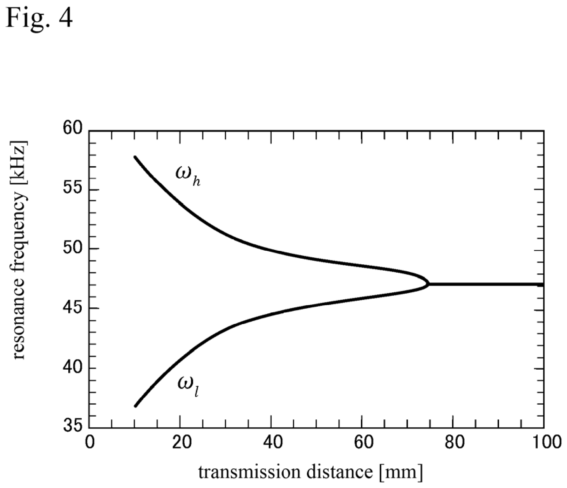

As shown in Fig. 3, since the relationship between the magnetic coupling coefficient $k_m$ and the transmission distance d between two coils (power supply coil and power receiving coil) can be calculated numerically, the relationship between the resonance frequency $\omega_h$ of Loop II or the resonance frequency $\omega_l$ of Loop I and the transmission distance d between two coils (power supply coil and power receiving coil) can also be calculated from Equations (5) and (6). Fig. 4 is a graph showing the relationship between the resonance frequency $\omega_h$ of Loop II or the resonance frequency $\omega_l$ of Loop I and the transmission distance d between two coils (power supply coil and power receiving coil).

As shown in Fig. 4, the resonance frequency $\omega_h$ of Loop II tends to decrease as the transmission distance d between the two coils becomes longer, and the resonance frequency $\omega_l$ of Loop I tends to increase as the transmission distance d becomes longer. In the example shown in Fig. 4, the resonance frequencies of the two resonance loops match when the transmission distance d between the two coils is around 70 mm. The transmission distance beyond the above described point is excluded from the discussion of the present invention since the PT symmetry is not preserved.

As described above, in the wireless power supply of the PT symmetry, since the inverter is used by causing self-oscillation, one of the resonance loops of either the resonance frequency $\omega_h$ of Loop II or the resonance frequency $\omega_l$ of Loop I is selected and self-oscillation occurs. However, when there is fluctuation in the transmission distance d during the operation and the resonance frequency $\omega_h$ of Loop II and the resonance frequency $\omega_l$ of Loop I suddenly switch unintentionally, the frequency of self-oscillation suddenly changes greatly (discontinuously). Thus, the power transmission is temporarily interrupted. Furthermore, since there is a difference in the magnitude of the transmission power and the power transmission efficiency depending on the mode, the switching between the resonance frequency $\omega_h$ of Loop II and the resonance frequency $\omega_l$ of Loop I causes a step difference in the magnitude of transmission power.

Therefore, in the present invention, based on the concept that the frequency of self-oscillation changes smoothly (continuously) if the resonance loop is fixed to either one even if the transmission distance d fluctuates, stable wireless power supply is enabled. Thus, a circuit configuration is provided with a phase adjustment circuit for advancing/delaying the phase of the voltage with respect to the current of the power supply coil 11 for the purpose of selecting and fixing either the resonance loop with the resonance frequency $\omega_h$ of Loop II or the resonance loop with the resonance frequency $\omega_l$ of Loop I.

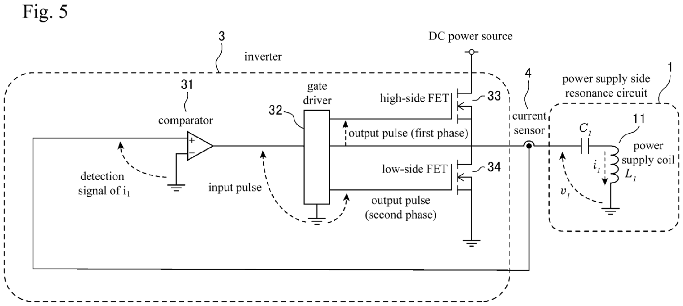

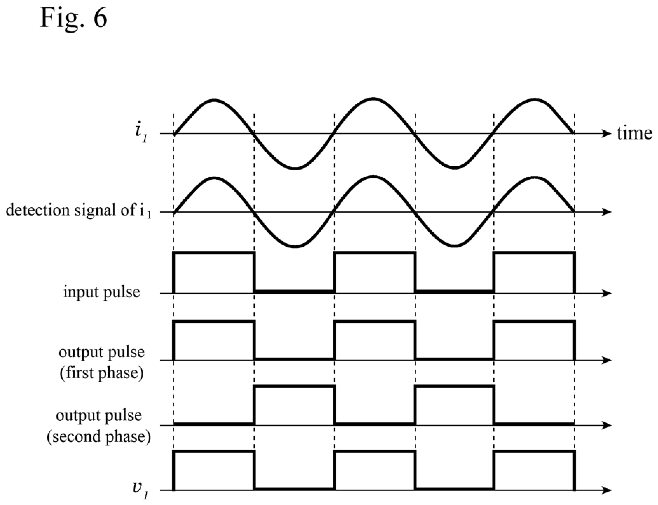

First, the circuit configuration of an inverter without a phase adjustment circuit as in the present invention will be explained. Class D inverter or Class E inverter is used as the inverter for the wireless power supply of the PT symmetry. Fig. 5 is a circuit diagram when Class D inverter is connected to the power supply side resonance circuit as an inverter used for the wireless power supply utilizing the PT symmetry. Actually, there exists a power receiving side resonance circuit that receives wireless power from the power supply side resonance circuit 1 shown in Fig. 5 and a load resistance connected to the power receiving side resonance circuit. However, these are omitted from Fig. 5. Fig. 6 is a schematic diagram showing the phase relationship of each waveform in the power supply side resonance circuit 1 shown in Fig. 5.

As explained in the prior art, the wireless power supply utilizing the PT symmetry replaces the AC power source in the conventional magnetic resonance wireless power supply technology with an inverter that behaves electrically similar to a negative resistor (i.e., an inverter that behaves as a negative resistance).

The inverter that behaves as a negative resistance is an inverter whose switching frequency and voltage amplitude are not fixed in advance, has a circuit configuration where the switching frequency is determined by the apparent resonance frequency of the wireless power supply circuit as seen from the output terminal of the inverter, and is an inverter where the switching frequency follows changes in the apparent resonance frequency of the wireless power supply circuit that may change due to changes in the transmission distance or the positional displacement of the two coils (power supply coil and power receiving coil) with fast response speed. The wireless power supply circuit refers to a circuit that includes the power supply side resonance circuit and the power receiving side resonance circuit and all circuits connected thereto. Furthermore, the apparent resonance frequency means the substantial resonance frequency that takes into account the interaction between the power supply side resonance circuit and the power receiving side resonance circuit since they interact with each other.

As shown in Fig. 5, the power supply side resonance circuit 1 is connected to an inverter 3 and a current sensor 4. The inverter 3 and the current sensor 4 realize a negative resistance circuit. Furthermore, a comparator 31, a gate driver 32, a high-side FET (field effect transistor) 33 and a low-side FET (field effect transistor) 34 are provided as elements constituting the inside of the inverter 3. The high-side FET 33 and the low-side FET 34 are the switching elements inside the inverter 3.

When the detection signal of the AC current $i_1$ flowing through the power supply coil 11 detected by the current sensor 4 is input to the comparator 31 shown in Fig. 5 and the input pulse that is the output of the comparator 31 is input to the gate driver 32, the gate driver 32 outputs two-phase output pulses (first phase output pulse and second phase output pulse) with a phase difference of 180° for alternately energizing/de-energizing (turning on/turning off) the high-side FET 33 and the low-side FET 34, which are the switching elements inside the inverter 3. The input pulse input to the gate driver 32 is created based on the AC current $i_1$ flowing through the power supply coil 11 or the AC magnetic field generated in the power supply coil 11.

At this time, the switch timing of the output pulses alternately output from the gate driver 32 to the high-side FET 33 and the low-side FET 34, which are the switching elements inside the inverter 3, is determined based on the input pulse to the gate driver 32. Here, "switch timing" refers to the time for turning on or turning off the high-side FET 33 and the low-side FET 34, which are the switching elements inside the inverter 3. The detection signal of the AC current $i_1$ detected by the current sensor 4 installed between the inverter 3 and the power supply side resonance circuit 1 is input to the comparator 31 to generate the input pulse described above.

Namely, the drive current of the power supply coil 11 in the power supply side resonance circuit 1, which is the output of the inverter 3, is fed back to the control side of the inverter 3 to control the output current of the inverter 3. This is called "feedback control."

Here, the detection signal of the AC current $i_1$ is an AC voltage signal in the same phase as the AC current $i_1$. In principle, the AC current $i_1$ and the input voltage $v_1$ of the power supply side resonance circuit are in the same phase (no phase difference). Thus, self-oscillation occurs due to positive feedback. The above described self-oscillation excites the power supply coil to realize wireless power supply.

However, in actual circuits, the AC current $i_1$ and the input voltage $v_1$ are not in the same phase. Actually, there is a time delay in the process of propagating the voltage signal through the circuit. Thus, the input voltage $v_1$ has a lagging phase with respect to the AC current $i_1$. The above described phase difference is called the initial phase difference. Note that the phase compensation circuit described in Patent Document 1 is a circuit for compensating the initial phase difference and making the AC current $i_1$ and the input voltage $v_1$ in the same phase. Thus, Patent Document 1 has a significantly different purpose from the present invention.

As described above, it is theoretically correct to make the AC current $i_1$ and the input voltage $v_1$ in the same phase. However, when the AC current $i_1$ and the input voltage $v_1$ are actually made in the same phase, the problem of frequent switching between the two resonance loops occurs as described above. Conversely, when a phase difference is intentionally created between the AC current $i_1$ and the input voltage $v_1$, it is found through experiments that stabilization occurs in one of the resonance loops.

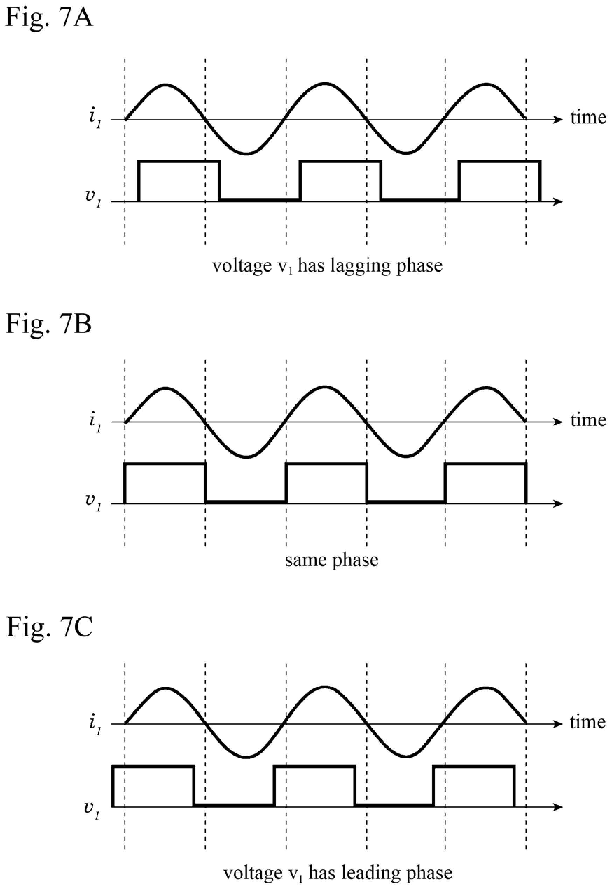

Figs. 7A to 7C show experimental results showing the phase relationship between the AC current $i_1$ and the input voltage $v_1$. Fig. 7A shows the case where the input voltage $v_1$ has a lagging phase with respect to the AC current $i_1$. Fig. 7B shows the case where the AC current $i_1$ and the input voltage $v_1$ are in the same phase. Fig. 7C shows the case where the input voltage $v_1$ has a leading phase with respect to the AC current $i_1$.

As shown in Fig. 7A, when the input voltage $v_1$ has the lagging phase with respect to the AC current $i_1$, the resonance loop with the resonance frequency $\omega_l$ of Loop I is selected. As shown in Fig. 7B, when the AC current $i_1$ and the input voltage $v_1$ are in an approximately same phase, the resonance loop becomes unstable. As shown in Fig. 7C, when the input voltage $v_1$ has a leading phase with respect to the AC current $i_1$, the resonance loop with the resonance frequency $\omega_h$ of Loop II is selected.

Next, the principle for enabling selection of the resonance loop by adjusting the phase relationship between the AC current $i_1$ and the input voltage $v_1$ will be explained. As described above, the inverter of the wireless power supply device in the embodiment 1 of the present invention self-oscillates by positively feeding back the current waveform of the AC current $i_1$. Therefore, the inverter can be regarded as an AC power source whose oscillation frequency is not fixed.

As shown in Fig. 5, the inverter 3 is connected to the power supply side resonance circuit 1. The power receiving side resonance circuit 2 (shown in Fig. 1 and Figs. 2A and 2B) and the load resistance $R_L$ (shown in Fig. 1 and Figs. 2A and 2B) are also indirectly connected to the inverter 3 through magnetic coupling.

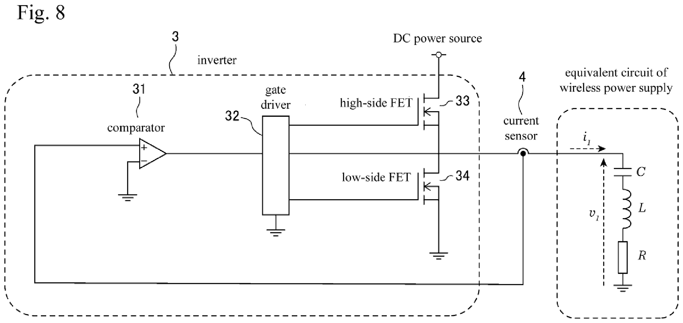

The circuit seen from the output terminal of the inverter 3 forms a resonance circuit, and the resonance circuit is shown as a simple equivalent circuit shown in Fig. 8. Fig. 8 is a circuit diagram showing an equivalent circuit of the wireless power supply connected to the inverter. Here, the resistance component of the circuit is R, the inductance component is L, and the capacitance component is C.

When the inverter self-oscillates at resonance frequency $\omega_c$, the magnitude of the inductive reactance and the capacitive reactance must satisfy the following Equation (9).

[Equation 9]

$$\omega_c L = 1/(\omega_c C) \quad \text{--- (9)}$$

Therefore, the reactance component of the resonance circuit as seen from the output terminal of the inverter becomes zero. Thus, the resonance circuit is equivalent to a circuit where only the resistance R is connected to the inverter. This is the original equivalent circuit when the PT symmetry is preserved. As described above, since only the resistance component R is connected to the inverter in the original equivalent circuit, the AC current $i_1$ and the input voltage $v_1$ are in the same phase.

However, in the present invention, a phase difference is forcibly created between the AC current $i_1$ and the input voltage $v_1$ although they are originally in the same phase.

For example, as shown in Fig. 7A, when the input voltage $v_1$ is delayed with respect to the AC current $i_1$, the equivalent circuit connected to the inverter becomes capacitive. In other words, when the input voltage $v_1$ is delayed with respect to the AC current $i_1$, the resonance frequency w deviates slightly from the original resonance frequency $\omega_c$. Thus, the equivalent circuit connected to the inverter becomes capacitive.

On the other hand, as shown in Fig. 7C, when the input voltage $v_1$ is advanced with respect to the AC current $i_1$, the resonance frequency $\omega$ deviates slightly from the original resonance frequency $\omega_c$. Thus, the equivalent circuit connected to the inverter becomes inductive.

The impedance Z of the equivalent circuit connected to the inverter can be expressed by the following Equation (10). Furthermore, the condition for the inductive is Equation (11).

[Equation 10]

$$Z = R + j(\omega L - 1/(\omega C)) \quad --- (10)$$

[Equation 11]

$$\omega L > 1/(\omega C) \quad --- (11)$$

Furthermore, from Equation (9), the inductance component L can be expressed as Equation (12). Thus, by substituting the Equation (12) into Equation (11), the inductive condition becomes Equation (13).

[Equation 12]

$$L = 1/(\omega_c^2 C) \quad --- (12)$$

[Equation 13]

$$\omega > \omega_c \quad --- (13)$$

Thus, when the input voltage $v_1$ is advanced with respect to the AC current $i_1$, the resonance frequency $\omega$ at that time becomes slightly higher than the original resonance frequency $\omega_c$.

As described above, the resonance frequency $\omega_c$ refers to either the resonance frequency $\omega_h$ of Loop II or the resonance frequency $\omega_l$ of Loop I. Since there is a relationship $\omega_h > \omega_l$, a sufficient condition for satisfying the relationship $\omega > \omega_c$ shown in Equation (13) is $\omega > \omega_h$. However, since $\omega$ is a frequency slightly higher than $\omega_h$, $\omega$ is a frequency approximately the same as $\omega_h$. Namely, when the input voltage $v_1$ is advanced with respect to the AC current $i_1$, the resonance loop with the resonance frequency $\omega_h$ of Loop II is selected.

On the other hand, the capacitive condition is Equation (14). Furthermore, from Equations (9) and (14), the capacitive condition is Equation (15).

[Equation 14]

$$\omega L < 1/(\omega C) \quad --- (14)$$

[Equation 15]

$$\omega < \omega_c \quad --- (15)$$

As described above, when the input voltage $v_1$ is delayed with respect to the AC current $i_1$, the resonance frequency $\omega$ at that time is slightly lower than the original resonance frequency $\omega_c$.

As described above, the resonance frequency $\omega_c$ refers to either the resonance frequency $\omega_h$ of Loop II or the resonance frequency $\omega_l$ of Loop I. Since there is a relationship $\omega_h > \omega_l$, a sufficient condition for satisfying the relationship $\omega < \omega_c$ shown in Equation (15) is $\omega < \omega_l$. However, since $\omega$ is a frequency slightly lower than $\omega_l$, $\omega$ is a frequency approximately the same as $\omega_l$. Namely, when the input voltage $v_1$ is delayed with respect to the AC current $i_1$, the resonance loop with the resonance frequency $\omega_l$ of Loop I is selected.

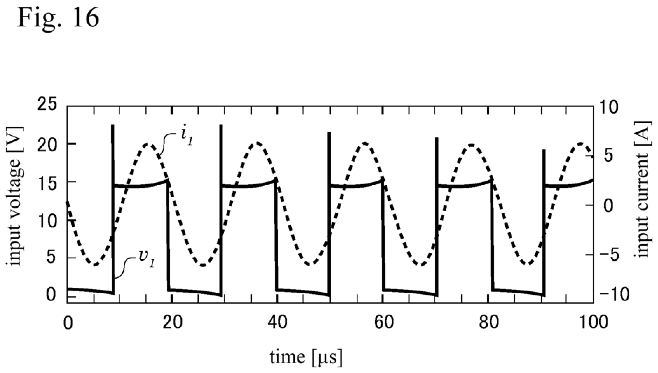

Therefore, actual circuit examples will be explained. As described above, it is confirmed that stabilization can be achieved in one of the resonance loops when a phase difference is intentionally created between the AC current $i_1$ and the input voltage $v_1$ (experimental results will be described later with reference to Fig. 16 to Fig. 18). Therefore, for the purpose of selecting and fixing the resonance loop with the resonance frequency $\omega_h$ of Loop II, when advancing the input voltage $v_1$ with respect to the AC current $i_1$, a phase advance circuit should be inserted before inputting the AC current detected by the current sensor to the comparator. However, since the phase advance circuit also functions as a high-pass filter, high-frequency noise components are preferentially passed and the S/N ratio is degraded. Thus, the phase advance circuit is unsuitable for stable operation.

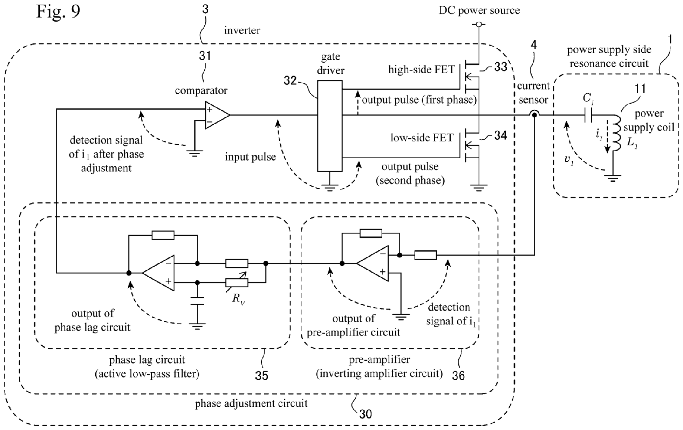

On the other hand, the phase lag circuit also functions as a low-pass filter and blocks high-frequency noise components. Thus, the phase lag circuit is suitable for stable operation. Of course, the phase lag circuit cannot create a phase advance circuit. Therefore, in actual circuits, as shown in Fig. 9, the phase advance is realized by configuring a phase adjustment circuit 30 with a combination of a pre-amplifier 36 and a phase lag circuit 35. Because of this, one of the two resonance loops is selected and fixed for achieving stable operation.

Fig. 9 is a circuit diagram showing an example of an inverter with a phase adjustment circuit and a power supply side resonance circuit in the embodiment 1 of the present invention. As shown in Fig. 9, the inverter 3 is connected to the power supply side resonance circuit 1 and a comparator 31, a gate driver 32, a high-side FET (field effect transistor) 33 and a low-side FET (field effect transistor) 34 are provided as the elements constituting the inside of the inverter 3, same as the circuit diagram shown in Fig. 5.

Furthermore, although Fig. 9 shows only the power supply side resonance circuit 1 and the inverter 3 and current sensor 4 connected to the power supply side resonance circuit 1, same as Fig. 1 and Figs. 2A and 2B, a magnetic resonance wireless power supply device includes the power supply side resonance circuit 1 including the power supply coil 11 and the power receiving side resonance circuit 2 including the power receiving coil 21, utilizes the PT symmetry (Parity-Time symmetry) and performs contactless power supply by causing magnetic resonance between the power supply coil 11 and the power receiving coil 21. When the power supply side resonance circuit 1 and the power receiving side resonance circuit 2 are regarded as a coupled resonance circuit mutually coupled by mutual inductance, two resonance loops ("Loop I resonance loop" and "Loop II resonance loop") are formed so that the resonance current flowing in the coupled resonance circuit can circulate.

However, in the case of the circuit in Fig. 9 (i.e., in one example of the circuit in the embodiment 1 of the present invention), the phase adjustment circuit 30 comprising a pre-amplifier (inverting amplifier circuit) 36 and a phase lag circuit 35 is installed before the input to the comparator 31 provided inside the inverter 3. Before the AC current $i_1$ based on the detection of the current or the magnetic field of the power supply coil 11 is input to the comparator 31, the phase is delayed by more than 180° by the phase adjustment circuit 30 (inverting amplifier circuit 36 and phase lag circuit 35) and input to the comparator 31. Thus, the phase control is performed as a leading phase. Because of this, "Loop II resonance loop" can be selected and fixed among the two resonance loops.

Namely, if the phase adjustment circuit 30 (pre-amplifier (inverting amplifier circuit) 36 and phase lag circuit 35) in Fig. 9 were not installed, the detection signal of the AC current $i_1$ flowing through the power supply coil 11 detected by the current sensor 4 would be input to the comparator 31 of the inverter 3. When the input pulse that is the output of the comparator 31 is input to the gate driver 32, the gate driver 32 outputs two-phase output pulses (first phase output pulse and second phase output pulse) with a phase difference of 180° for alternately energizing/de-energizing (turning on/turning off) the high-side FET 33 and the low-side FET 34, which are the switching elements inside the inverter 3. The input pulse input to the gate driver 32 is created based on the AC current $i_1$ flowing through the power supply coil 11 or the AC magnetic field generated in the power supply coil 11.

However, in Fig. 9, the pre-amplifier (inverting amplifier circuit) 36 and the phase lag circuit 35 are installed before the input to the comparator 31. Before the AC current $i_1$ based on the detection of the current or the magnetic field of the power supply coil 11 is input to the comparator 31, the signal delayed by more than 180° by the inverting amplifier circuit 36 and the phase lag circuit 35 is input to the comparator 31. When the input pulse that is the output of the comparator 31 is input to the gate driver 32, the gate driver 32 outputs two-phase output pulses (first phase output pulse and second phase output pulse) with a phase difference of 180° for alternately energizing/de-energizing (turning on/turning off) the high-side FET 33 and the low-side FET 34, which are the switching elements inside the inverter 3, and the input pulse input to the gate driver 32 is created based on the AC current $i_1$ flowing through the power supply coil 11 or the AC magnetic field generated in the power supply coil 11, same as the inverter 3 shown in Fig. 5.

At this time, the switch timing of the output pulses alternately output from the gate driver 32 to the high-side FET 33 and the low-side FET 34, which are the switching elements inside the inverter 3, is determined based on the input pulse to the gate driver 32. Here, "switch timing" refers to the time for turning on or turning off the high-side FET 33 and the low-side FET 34, which are the switching elements inside the inverter 3, as described above. The detection signal of the AC current $i_1$ detected by the current sensor 4 installed between the inverter 3 and the power supply side resonance circuit 1 is phase-adjusted by the pre-amplifier (inverting amplifier circuit) 36 and the phase lag circuit 35, and the signal is input to the comparator 31 to generate the input pulse described above.

Namely, in the case of Fig. 9, the switch timing of the output pulses alternately output from the gate driver 32 to the high-side FET 33 and the low-side FET 34, which are the switching elements inside the inverter 3, is determined based on the input pulse generated by inputting the signal after performing the phase control by the feedback control of the leading phase or the lagging phase to the comparator 31 using the current phase or the magnetic field phase of the power supply coil 11 detected by the current sensor 4 (i.e., the signal after adjusting the phase relationship by the phase adjustment circuit 30) as a reference.

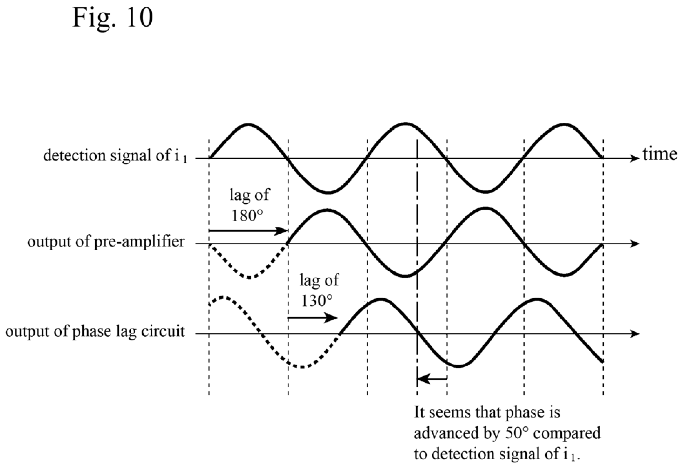

Here, since the pre-amplifier 36 is an inverting amplifier circuit, when the detection signal of the AC current $i_1$ is input to the pre-amplifier 36, the phase of the output signal is inverted by 180° with respect to the input signal as shown in Fig. 10. Fig. 10 is a schematic diagram showing voltage waveforms of each part of the phase adjustment circuit (pre-amplifier 36 and phase lag circuit 35) shown in Fig. 9. After that, the phase is further delayed at the output of the phase lag circuit (low-pass filter) 35 using an operational amplifier. For example, when the phase lag circuit 35 generates a phase lag of 130°, the phase lag including the pre-amplifier 36 is 180 + 130 = 310°. Namely, since the phase is advanced by 360 - 310 = 50° with a delay of one cycle (360°), a phase advance can be realized equivalently. In other words, the AC current $i_1$ is delayed by more than 180° and input to the comparator 31.

Furthermore, in Fig. 9, the negative resistance circuit connected to the power supply side resonance circuit 1 is described as using the inverter 3 and the current sensor 4, but a magnetic sensor may be used instead of the current sensor 4. Since the current phase and the magnetic field phase coincide, the current may be detected by the current sensor 4 to detect the current phase and detect the AC current based on the current phase, or the magnetic field may be detected by the magnetic sensor to detect the magnetic field phase and detect AC current based on the magnetic field phase. Namely, the sensor constituting the negative resistance circuit together with the inverter 3 may be any sensor capable of detecting the current or the magnetic field of the power supply coil 11 in the power supply side resonance circuit 1. This applies similarly to Fig. 5, Fig. 8 and Fig. 11 and subsequent figures described later.

Namely, the circuit shown in Fig. 9 is a device that detects the current or the magnetic field of the power supply coil 11 for oscillation of the inverter 3 connected to the power supply side resonance circuit 1, detects zero-crossing of the voltage or the current of the power supply coil 11 based on the detected current or the detected magnetic field, and causes self-oscillation. For the purpose of selecting and fixing the resonance loop with the resonance frequency $\omega_h$ of Loop II ("Loop II resonance loop"), the AC current $i_1$ detected by the current sensor 4 or the magnetic sensor (not illustrated) of the power supply coil 11 is delayed by more than 180° by inserting the pre-amplifier (inverting amplifier circuit) 36 and the phase lag circuit 35 before the input to the comparator 31 inside the inverter 3 to advance the phase of the voltage with respect to the current of the power supply coil 11. Thus, the control is performed as a leading phase. Namely, the leading phase is realized by rotating the lagging phase more than 180°. This can solve the problem that the lead-phase control is vulnerable to noise, causing unstable operation.

As described above, the power supply side resonance circuit 1 is connected to the inverter 3 and the sensor (current sensor 4 in Fig. 9) that detects the current or the magnetic field of the power supply coil 11. The inverter 3 includes the phase adjustment circuit 30 that performs the phase control by the feedback control of the leading phase or the lagging phase using the current phase based on the current of the power supply coil 11 detected by the sensor (or the magnetic field phase based on the magnetic field of the power supply coil 11) as a reference (i.e., provided with the phase adjustment circuit 30 capable of adjusting the phase relationship between the AC voltage applied to the power supply side resonance circuit 1 and the AC current flowing through the power supply coil 11). The switch timing, which is the time for turning on or turning off the switching elements inside the inverter 3, is determined based on the pulses generated by the signal after the phase relationship is adjusted by the phase adjustment circuit 30. Thus, one of the two resonance loops is selected and fixed.

Furthermore, in the case of the embodiment (circuit) shown in Fig. 9, the comparator 31 is provided inside the inverter 3, and the phase lag circuit 35 is installed before the input to the comparator 31 as the phase adjustment circuit 30. For the purpose of selecting the "Loop II resonance loop" among the two resonance loops, the inverter 3 performs the control to adjust the phase relationship as the leading phase by having the phase lag circuit 35 delay the AC current by more than 180° and input it to the comparator 31 before the AC current based on the current or the magnetic field of the power supply coil 11 detected by the sensor (current sensor 4 in Fig. 9) is input to the comparator 31 to advance the phase of AC voltage applied to the power supply side resonance circuit 1 with respect to the AC current flowing through the power supply coil 11.

In the embodiment (circuit) shown in Fig. 9, a low-pass filter using an operational amplifier is used as the phase lag circuit 35 as a specific example of the phase adjustment circuit 30. However, when a large phase lag of about 130° is generated with the low-pass filter, the gain (output amplitude/input amplitude) of the low-pass filter is too small and the amplitude of the output signal is too small. In that case, there is a method of using a time delay circuit instead of the low-pass filter.

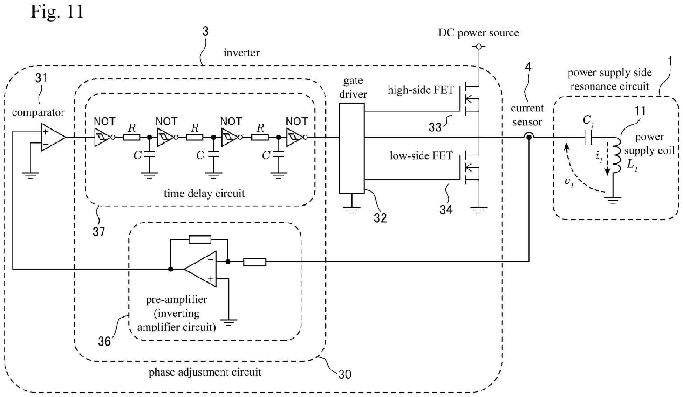

Fig. 11 is a circuit diagram showing an example of an inverter with a time delay circuit and a power supply side resonance circuit in the embodiment 1 of the present invention. As shown in Fig. 11, the inverter 3 is connected to the power supply side resonance circuit 1, and the comparator 31, the gate driver 32, the high-side FET (field effect transistor) 33, and the low-side FET (field effect transistor) 34 are provided as the elements constituting the inside of the inverter 3, same as the circuit diagrams shown in Fig. 5 and Fig. 9.

However, in the case of the circuit in Fig. 11 (i.e., in another example of the circuit in the embodiment 1 of the present invention), the pre-amplifier (inverting amplifier circuit) 36 is installed before the input to the comparator 31 provided inside the inverter 3, and a time delay circuit 37 is installed after the output of the comparator 31. Thus, the phase control is performed by controlling delay time. In the case of Fig. 11, the phase adjustment circuit 30 includes at least the time delay circuit 37.

Namely, the circuit shown in Fig. 11 performs the phase control by controlling the delay time by inputting the inputting AC current $i_1$ detected by the current sensor 4 or the magnetic sensor (not illustrated) of the power supply coil 11 to the comparator 31 inside the inverter 3 and inserting the time delay circuit 37 after the output of the comparator 31 to advance the phase of the voltage with respect to the current of the power supply coil 11 for the purpose of selecting and fixing the resonance loop with the resonance frequency $\omega_h$ of Loop II ("Loop II resonance loop").

A large phase lag of about 130° is generated by connecting multiple stages of the time delay circuits 37 combining NOT-type logic elements with Schmitt triggers and RC integration circuits after the comparator 31. Namely, real-time control using NOT circuits and RC integration circuits is realized for controlling switch signals input to the comparator 31. Thus, the problem of analog circuit phase delays having frequency dependence can be solved. Note that logic elements do not necessarily need to have Schmitt triggers. Furthermore, logic elements can be realized with buffer circuits instead of NOT-type.

As described above, in the embodiment (circuit) shown in Fig. 11, the comparator 31 is provided inside the inverter 3, and the AC current based on the current or the magnetic field of the power supply coil 11 detected by the sensor (current sensor 4 in Fig. 11) is configured to be input to the comparator 31. Furthermore, the time delay circuit 37 is installed after the output of the comparator 31 as the phase adjustment circuit 30. The inverter 3 performs the control to adjust the phase relationship by controlling delay time with the time delay circuit 37. Thus, one of the two resonance loops is selected and fixed.

In the actual circuit examples of Fig. 9 and Fig. 11, the phase of the AC current $i_1$ is detected by attaching the current sensor 4 to the connection line of the power supply coil 11 to detect the current of the power supply coil 11 (the current of the power supply side resonance circuit 1). The same effect can be realized by attaching the magnetic sensor (not illustrated) near the power supply coil 11 to detect the magnetic field of the power supply coil 11 (magnetic field of the power supply side resonance circuit 1). The magnetic sensor may be a Hall element or a magnetic sensor called a loop coil formed by looping wire. In this case, the negative resistance circuit comprises the inverter 3 and the magnetic sensor.

Thus, in Fig. 9, the phase is controlled by installing the phase lag circuit (low-pass filter) 35 before the comparator 31. In Fig. 11, the phase is controlled by placing the time delay circuit 37 after the comparator 31. Another possible embodiment is to use a circuit called an all-pass filter that can control only the phase instead of the time delay circuit 37 shown in Fig. 11.

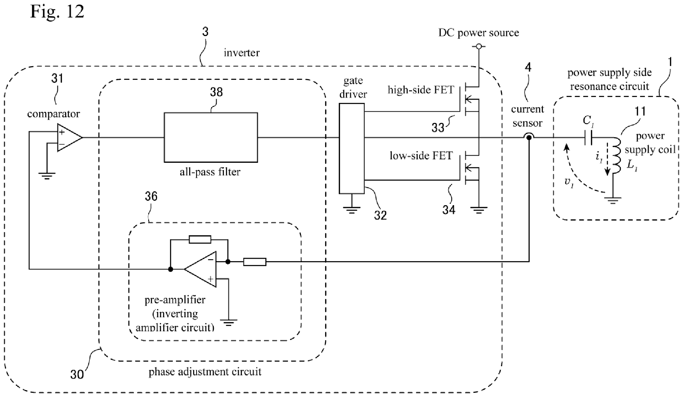

Fig. 12 is a circuit diagram showing an example of an inverter with an all-pass filter and a power supply side resonance circuit in the embodiment 1 of the present invention. As shown in Fig. 12, the inverter 3 is connected to the power supply side resonance circuit 1, and the comparator 31, the gate driver 32, the high-side FET (field effect transistor) 33 and the low-side FET (field effect transistor) 34 are provided as the elements constituting the inside of the inverter 3, same as the circuit diagrams shown in Fig. 5, Fig. 9 and Fig. 11.

However, in the case of the circuit in Fig. 12 (i.e., in another example of the circuit in the embodiment 1 of the present invention), the pre-amplifier (inverting amplifier circuit) 36 is installed before the input to the comparator 31 provided inside the inverter 3, and an all-pass filter 38 is installed after the output of the comparator 31. Thus, the phase control is performed with the all-pass filter 38.

Namely, the circuit shown in Fig. 12 performs the phase control with the all-pass filter 38 by inputting the AC current $i_1$ detected by the current sensor 4 or the magnetic sensor (not illustrated) of the power supply coil 11 to the comparator 31 inside the inverter 3 and inserting the all-pass filter 38 after the output of the comparator 31 to advance the phase of the voltage with respect to the current of the power supply coil 11 for the purpose of selecting and fixing the resonance loop with the resonance frequency $\omega_h$ of Loop II ("Loop II resonance loop").

As described above, in the embodiment (circuit) shown in Fig. 12, the comparator 31 is provided inside the inverter 3, and the AC current based on the current or the magnetic field of the power supply coil 11 detected by the sensor (current sensor 4 in Fig. 12) is configured to be input to the comparator 31. Furthermore, the all-pass filter 38 is installed after the output of the comparator 31 as the phase adjustment circuit 30. The inverter 3 performs the control to adjust the phase relationship with the all-pass filter 38. Thus, one of the two resonance loops is selected and fixed.

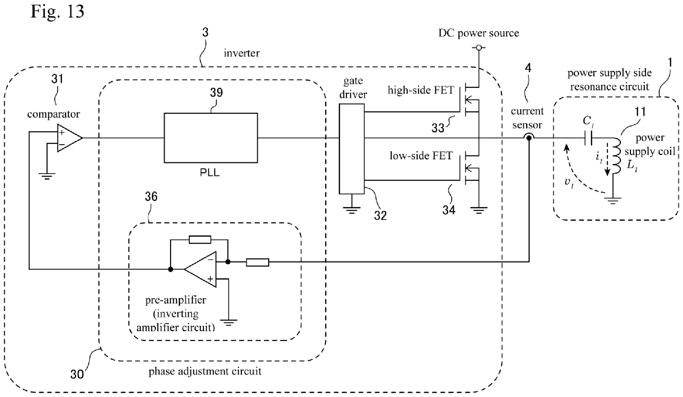

Furthermore, as shown in Fig. 13, a method of controlling the phase using a PLL (phase-locked loop) 39 instead of the time delay circuit 37 shown in Fig. 11 or the all-pass filter 38 shown in Fig. 12 is also conceivable. Fig. 13 is a circuit diagram showing an example of an inverter with a PLL (phase-locked loop) and a supply side resonance circuit in the embodiment 1 of the present invention. As shown in Fig. 13, the inverter 3 is connected to the power supply side resonance circuit 1, and the comparator 31, the gate driver 32, the high-side FET (field effect transistor) 33 and the low-side FET (field effect transistor) 34 are provided as the elements constituting the inside of the inverter 3, same as the circuit diagrams shown in Fig. 5, Fig. 9, Fig. 11 and Fig. 12.

However, in the case of the circuit in Fig. 13 (i.e., in another example of the circuit in the embodiment 1 of the present invention), the pre-amplifier (inverting amplifier circuit) 36 is installed before the input to the comparator 31 provided inside the inverter 3, and a PLL (phase-locked loop) 39 is installed after the output of the comparator 31. Thus, the phase control is performed with the PLL (phase-locked loop) 39.

Namely, the circuit shown in Fig. 13 performs the phase control by controlling phase advance/lag with the PLL (phase-locked loop) 39 by inputting the AC current $i_1$ detected by the current sensor 4 or the magnetic sensor (not illustrated) of the power supply coil 11 to the comparator 31 inside the inverter 3 and inserting the PLL (phase-locked loop) 39 after the output of the comparator 31 to advance the phase of the voltage with respect to the current of the power supply coil 11 for the purpose of selecting and fixing the resonance loop with the resonance frequency $\omega_h$ of Loop II ("Loop II resonance loop").

As described above, in the embodiment (circuit) shown in Fig. 13, the comparator 31 is provided inside the inverter 3, and the AC current based on the current or the magnetic field of the power supply coil 11 detected by the sensor (current sensor 4 in Fig. 13) is configured to be input to the comparator 31. Furthermore, the PLL (phase-locked loop) 39 is installed after the output of the comparator 31 as the phase adjustment circuit 30. The inverter 3 performs the control to adjust the phase relationship by advancing or delaying the phase of the AC voltage applied to the power supply side resonance circuit 1 with respect to the AC current flowing through the power supply coil 11 using the PLL (phase-locked loop) 39. Thus, one of the two resonance loops is selected and fixed.

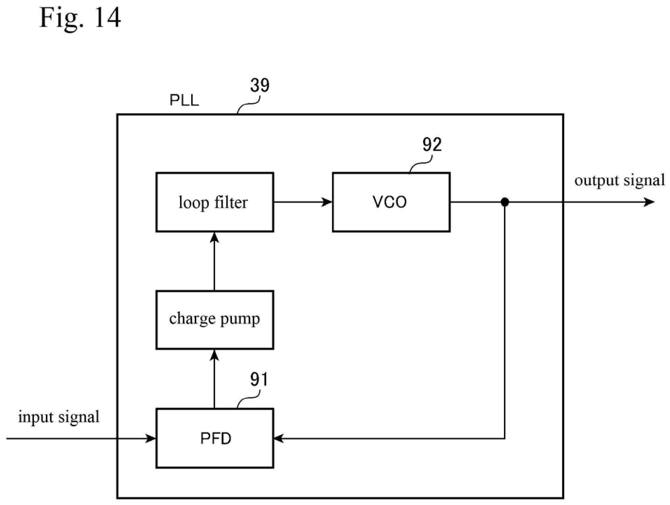

Fig. 14 is a block diagram showing an example of specific internal functions of the PLL (phase-locked loop) 39. As shown in Fig. 14, the PLL (phase-locked loop) 39 includes at least a PFD (phase detector) 91 and a VCO (voltage controlled oscillator) 92. The PFD (phase detector) 91 calculates the phase difference between the input signal that is the reference frequency and the feedback signal of the output from the VCO (voltage controlled oscillator) 92 whose frequency changes according to voltage, and the phases of the input signal and the output signal are synchronized by inputting the phase difference to the VCO (voltage controlled oscillator) 92. Therefore, the frequency range of the output signal of the PLL (phase-locked loop) 39 can be limited by giving some offset voltage to the input voltage of the VCO (voltage controlled oscillator) 92.

For example, when the frequency range of the resonance frequency $\omega_h$ of Loop II is 70 kHz to 90 kHz and the frequency range of the resonance frequency $\omega_l$ of Loop I is 50 kHz to 70 kHz, the operation at the resonance frequency $\omega_l$ of Loop I will not occur by making the frequency range of the output signal of the PLL (phase-locked loop) 39 from 70 kHz to 90 kHz. Thus, the stability of the operation at the resonance frequency $\omega_h$ of Loop II is enhanced. Namely, the operational stability when one of the two resonance loops is selected can be enhanced by controlling the input voltage of the VCO (voltage controlled oscillator) 92 to limit the oscillation frequency of the VCO (voltage controlled oscillator) 92 and limiting the frequency range of the output signal of the PLL (phase-locked loop) 39.

Here, the AC signal based on the current detected by the current sensor 4 shown in Fig. 13 is inverted by the pre-amplifier (inverting amplifier circuit) 36 and input to the comparator 31, and the input pulse generated by the comparator 31 is the input signal of the PLL (phase-locked loop) 39. Therefore, when the output signal of the PLL (phase-locked loop) 39 is input to the gate driver 32, the frequency or the phase can be controlled by controlling the input voltage of the VCO (voltage controlled oscillator) 92 (controlling the control value of VCO 92) compared to the positive feedback without the phase control. By using the above described control, one of either the resonance frequency $\omega_h$ of Loop II or the resonance frequency $\omega_l$ of Loop I can be selected and fixed as the resonance frequency of the power supply side resonance circuit 1. As another method, it is also possible to limit the oscillation frequency of the VCO (voltage controlled oscillator) 92 of the PLL (phase-locked loop) 39 and control so that only the resonance frequency $\omega_h$ of Loop II oscillates or only the resonance frequency $\omega_l$ of Loop I oscillates.

As described above, only the resonance frequency $\omega_h$ of Loop II is inevitably selected by limiting the variation range of the oscillation frequency of the VCO (voltage controlled oscillator) 92 in the PLL (phase-locked loop) 39 so that oscillation absolutely cannot occur at the resonance frequency $\omega_l$ of Loop I. Thus, it is possible to forcibly select and fix to the resonance frequency $\omega_h$ of Loop II. Namely, the output frequency of the PLL (phase-locked loop) 39 can be limited by using the PLL (phase-locked loop) 39 with the frequency limitation given to the VCO (voltage controlled oscillator) 92. Thus, the resonance loop can be fixed to either one and it is possible to prevent unstable switching from occurring.

Because of this, the problem of the current loops switching randomly due to the positional fluctuations of the power supply coil and the power receiving coil can be prevented during wireless power supply. As described above, since the PLL (phase-locked loop) 39 is added, the phase control is enabled by the PLL and the stable operation can be expected with reduced phase fluctuations. Thus, the merit of improving the operational stability can be provided.

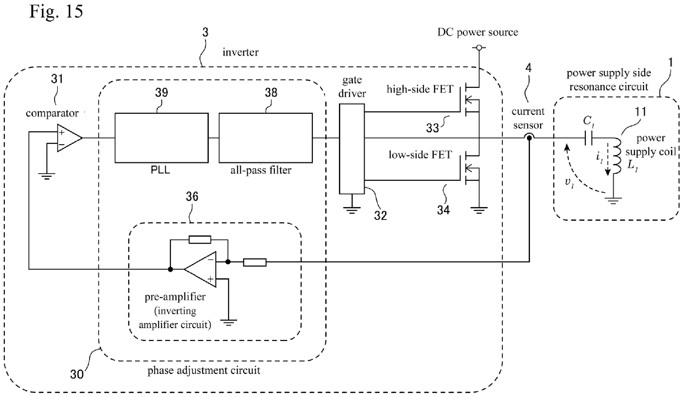

Furthermore, as shown in Fig. 15, a method of controlling the phase using both the all-pass filter 38 and the PLL (phase-locked loop) 39 is also conceivable instead of the time delay circuit 37 shown in Fig. 11, the all-pass filter 38 shown in Fig. 12 or the PLL (phase-locked loop) 39 shown in Fig. 13. Fig. 15 is a circuit diagram showing an example of an inverter with an all-pass filter and a PLL (phase-locked loop) and a power supply side resonance circuit in the embodiment 1 of the present invention. As shown in Fig. 15, the inverter 3 is connected to the power supply side resonance circuit 1, and the comparator 31, the gate driver 32, the high-side FET (field effect transistor) 33 and the low-side FET (field effect transistor) 34 are provided as the elements constituting the inside of the inverter 3, same as the circuit diagrams shown in Fig. 5, Fig. 9, Fig. 11, Fig. 12 and Fig. 13.

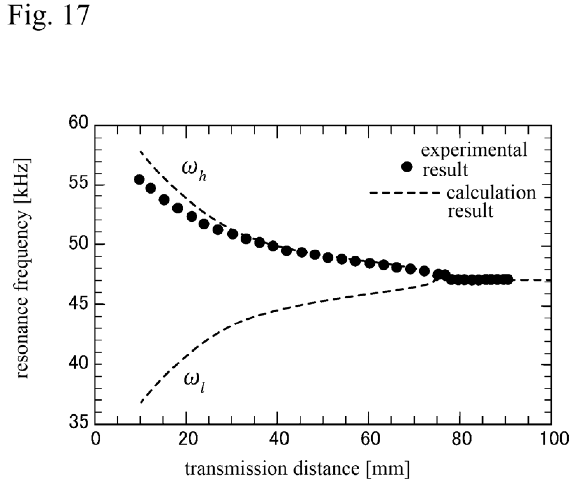

Fig. 16 is a graph showing measured waveforms of the AC current $i_1$ and the input voltage $v_1$ when the input voltage $v_1$ is adjusted to have the leading phase with respect to the AC current $i_1$ in an actual device in the embodiment 1 of the present invention. The dashed line shows the AC current $i_1$, and the solid line shows the input voltage $v_1$. Namely, Fig. 16 shows the phase difference between the AC voltage applied to the power supply side resonance circuit 1 and the AC current flowing through the power supply coil 11. Furthermore, Fig. 17 is a graph showing results of measuring changes in the resonance frequency when the distance between the power supply coil 11 provided in the power supply side resonance circuit 1 and the power receiving coil 21 provided in the power receiving side resonance circuit 2 (i.e., the transmission distance d between the two coils) is varied in the phase relationship in Fig. 16. The circle marks • show the experimental results, and the dashed line shows the calculation results.

In the experiments, when the phase difference shown in Fig. 16 is 30 to 35 degrees (i.e., when the AC voltage $v_1$ is made to have the leading phase of 30 to 35 degrees with respect to the AC current $i_1$), it was confirmed that the resonance frequency $\omega_h$ of Loop II is stably selected and fixed as shown in Fig. 17. It can be seen from Fig. 17 that the resonance loop with the resonance frequency $\omega_h$ of Loop II is always selected and fixed at any transmission distance (i.e., even when the transmission distance d changes).

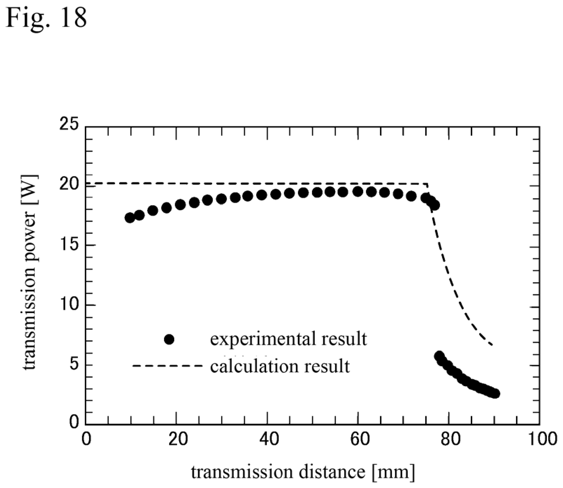

Fig. 18 is a graph showing results of measuring the transmission power when the transmission distance d between the two coils is varied. The circle marks • show the experimental results, and the dashed line shows the calculation results. It can be confirmed from Fig. 18 that the power supply is always possible at any transmission distance (i.e., even when the transmission distance d changes).

As described above, according to the present invention, in a magnetic resonance wireless power supply device utilizing PT symmetry and performing contactless power supply by causing magnetic resonance between the power supply coil and the power receiving coil, it is possible to select and fix the resonance loop without being affected by surrounding environment and without imposing the restriction on the design of the power supply coil and the power receiving coil by providing a phase adjustment circuit for adjusting the phase. Namely, without being affected by the surrounding environment and without being influenced by the selection of frequencies suitable for wireless power supply, coil core shapes, materials and the like (without requiring adjustments by coil design), it is possible to select and fix one of the two resonance loops without imposing the restriction on the design of the power supply coil and the power receiving coil. Thus, coils can be made in free shapes and dimensions.

Note that any component of the embodiment can be modified, or any component of the embodiment can be omitted within the scope of the present invention.

Industrial Applicability

The magnetic resonance wireless power supply device of the present invention can be widely applied to wireless power supply in various environments, not only short-distance wireless power supply such as mobile phone charging, but also environments with water around such as underwater drones, and environments with many metals around such as power transmission to equipment in factories.

Description of symbols

    1: power supply side resonance circuit
    2: power receiving side resonance circuit
    3: inverter
    4: current sensor
    11: power supply coil
    21: power receiving coil
    30: phase adjustment circuit
    31: comparator
    32: gate driver
    33: high-side FET
    34: low-side FET
    35: phase lag circuit
    36: pre-amplifier (inverting amplifier circuit)
    37: time delay circuit
    38: all-pass filter
    39: PLL (phase-locked loop)
    91: PFD (phase detector)
    92: VCO (voltage controlled oscillator)

**Claims**

**1.**    A magnetic resonance wireless power supply device utilizing Parity-Time symmetry, the magnetic resonance wireless power supply device comprising:

a power supply side resonance circuit including a power supply coil; and
a power receiving side resonance circuit including a power receiving coil, wherein
an electric power is transferred contactlessly by causing a magnetic resonance between the power supply coil and the power receiving coil,
when the power supply side resonance circuit and the power receiving side resonance circuit are regarded as a coupled resonance circuit coupled to each other via mutual inductance, two resonance loops of "Loop I resonance loop" and "Loop II resonance loop" are formed so that a resonance current flowing through the coupled resonance circuit can circulate,
an inverter and a sensor that detects a current or a magnetic field of the power supply coil are connected to the power supply side resonance circuit,
the inverter includes a phase adjustment circuit capable of adjusting a phase relationship between an AC voltage applied to the power supply side resonance circuit and an AC current flowing through the power supply coil using a current phase of the current of the power supply coil and detected by the sensor or a magnetic field phase of the magnetic field of the power supply coil and detected by the sensor as a reference, and
a switch timing, which is a time for turning on or turning off a switching element inside the inverter, is determined based on a pulse generated by a signal after the phase relationship is adjusted by the phase adjustment circuit so that one of the two resonance loops is selected and fixed.

2. The magnetic resonance wireless power supply device according to claim 1, wherein

a comparator is provided inside the inverter,
a phase lag circuit is installed before an input to the comparator as the phase adjustment circuit, and
the inverter performs a control to adjust the phase relationship as a leading phase by having the phase lag circuit delay the AC current by more than 180° and input the AC current to the comparator before the AC current generated based on the current or the magnetic field of the power supply coil and detected by the sensor is input to the comparator so that a phase of the AC voltage applied to the power supply side resonance circuit is advanced with respect to the AC current flowing through the power supply coil for a purpose of selecting "Loop II resonance loop" among the two resonance loops.

3. The magnetic resonance wireless power supply device according to claim 1, wherein

a comparator is provided inside the inverter,
the AC current generated based on the current or the magnetic field of the power supply coil and detected by the sensor is configured to be input to the comparator,
a time delay circuit is installed after an output of the comparator as the phase adjustment circuit, and
the inverter performs a control to adjust the phase relationship by controlling a delay time using the time delay circuit.

4. The magnetic resonance wireless power supply device according to claim 1, wherein

a comparator is provided inside the inverter,
the AC current generated based on the current or the magnetic field of the power supply coil and detected by the sensor is configured to be input to the comparator,
an all-pass filter is installed after an output of the comparator as the phase adjustment circuit, and
the inverter performs a control to adjust the phase relationship using the all-pass filter.

5. The magnetic resonance wireless power supply device according to claim 1, wherein

a comparator is provided inside the inverter,
the AC current generated based on the current or the magnetic field of the power supply coil and detected by the sensor is configured to be input to the comparator,
a PLL (phase-locked loop) is installed after an output of the comparator as the phase adjustment circuit, and
the inverter performs a control to adjust the phase relationship by advancing or delaying a phase of the AC voltage applied to the power supply side resonance circuit with respect to the AC current flowing through the power supply coil using the PLL (phase-locked loop).

6. The magnetic resonance wireless power supply device according to claim 5, wherein

the PLL (phase-locked loop) includes at least a VCO (voltage controlled oscillator), and
an oscillation frequency of the VCO (voltage controlled oscillator) is limited and a frequency range of output signal of the PLL (phase-locked loop) is limited by controlling an input voltage of the VCO (voltage controlled oscillator).

Fig. 1

Fig. 2A

power supply side
resonance circuit

power receiving side
resonance circuit

$k_m$

inverter

S-S topology

Fig. 2B

power supply side
resonance circuit

power receiving side
resonance circuit

$k_m$

inverter

S-P topology

Fig. 3

Fig. 4

Fig. 5

Fig. 6

$i_1$

detection signal of i $_1$

input pulse

output pulse
(first phase)

output pulse
(second phase)

$v_1$

time

## Fig. 7A

voltage v$_1$ has lagging phase

## Fig. 7B

same phase

## Fig. 7C

voltage v$_1$ has leading phase

Fig. 8

Fig. 9

Fig. 10

detection signal of i₁

lag of 180°

output of pre-amplifier

lag of 130°

output of phase lag circuit

time

It seems that phase is advanced by 50° compared to detection signal of i₁.

Fig. 11

Fig. 12

Fig. 13

Fig. 14

Fig. 15

Fig. 16

Fig. 17

Fig. 18

## INTERNATIONAL SEARCH REPORT

| | International application No. |
|---|---|
| | **PCT/JP2024/028581** |

| | | |
|---|---|---|
| **A.** | **CLASSIFICATION OF SUBJECT MATTER** | |
| | *H02J 50/12*(2016.01)i | |
| | FI:   H02J50/12 | |
| According to International Patent Classification (IPC) or to both national classification and IPC | | |

| **B.** | **FIELDS SEARCHED** |
|---|---|
| Minimum documentation searched (classification system followed by classification symbols) | |
| H02J50/12 | |
| Documentation searched other than minimum documentation to the extent that such documents are included in the fields searched | |
| Published examined utility model applications of Japan 1922-1996<br>Published unexamined utility model applications of Japan 1971-2024<br>Registered utility model specifications of Japan 1996-2024<br>Published registered utility model applications of Japan 1994-2024 | |
| Electronic data base consulted during the international search (name of data base and, where practicable, search terms used) | |

| **C.** | **DOCUMENTS CONSIDERED TO BE RELEVANT** | |
|---|---|---|
| Category* | Citation of document, with indication, where appropriate, of the relevant passages | Relevant to claim No. |
| A | JP 2022-121324 A (KAKE EDUCATIONAL INST.) 19 August 2022 (2022-08-19)<br>entire text, all drawings | 1-6 |
| A | JP 2023-088134 A (OMRON CORPORATION) 26 June 2023 (2023-06-26)<br>entire text, all drawings | 1-6 |
| A | US 2022/0385107 A1 (THE BOARD OF TRUSTEES OF THE LELAND STANFORD JUNIOR UNIVERSITY) 01 December 2022 (2022-12-01)<br>entire text, all drawings | 1-6 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **27 August 2024** | **10 September 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/028581**

| Patent document cited in search report | | | Publication date (day/month/year) | Patent family member(s) | | | Publication date (day/month/year) |
|---|---|---|---|---|---|---|---|
| JP | 2022-121324 | A | 19 August 2022 | US | 2024/0120775 | A1 | |
| | | | | entire text, all drawings | | | |
| | | | | EP | 4290540 | A1 | |
| | | | | CN | 116806404 | A | |
| JP | 2023-088134 | A | 26 June 2023 | US | 2023/0187982 | A1 | |
| | | | | entire text, all drawings | | | |
| | | | | DE | 102022130371 | A1 | |
| US | 2022/0385107 | A1 | 01 December 2022 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2022121324 A

### Non-patent literature cited in the description

- **SID ASSAWAWORRARIT** ; **XIAOFANG YU** ; **SHAN-HUI FAN**. Robust wireless power transfer using a nonlinear parity-time-symmetric circuit. *Nature*, 15 June 2017, vol. 546, 387-390
- **A.P.SAMPLE** ; **D.T.MEYER** ; **J.R.SMITH**. Analysis, experimental results, and range adaptation of magnetically coupled resonators for wireless power transfer. *IEEE Trans. Ind. Electron*, 2011, vol. 58 (2), 544-554
- **J. ZHOU** ; **B. ZHANG** ; **W. XIAO** ; **D. QIU** ; **Y. CHEN**. Nonlinear parity-time-symmetric model for constant efficiency wireless power transfer: application to a drone-in-flight wireless charging platform. *IEEE Trans. Ind. Electron*, August 2019, vol. 66 (5), 4097-4107
- **H. ISHIDA** ; **T. KYODEN** ; **H. FURUKAWA**. Application of parity-time symmetry to low-frequency wireless power transfer system. *IEEJ J. Ind. Appl*, 2022, vol. 11 (1), 59-68